(19) Europäisches Patentamt
European Patent Office
Office européen des brevets

(11) EP 2 610 932 A1

(12) **EUROPEAN PATENT APPLICATION**

(43) Date of publication:
**03.07.2013 Bulletin 2013/27**

(51) Int Cl.:
***H01L 33/50*** *(2010.01)* *C09K 11/77* *(2006.01)*

(21) Application number: **12199447.9**

(22) Date of filing: **27.12.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.12.2011 JP 2011288201**

(71) Applicants:
- **NITTO DENKO CORPORATION**
  **Ibaraki-shi,**
  **Osaka 567-8680 (JP)**
- **Idec Corporation**
  **Osaka-shi**
  **Osaka 532-8550 (JP)**

(72) Inventors:
- **Kono, Hiroki**
  **Osaka, 567-8680 (JP)**
- **Kondo, Takashi**
  **Osaka, 567-8680 (JP)**
- **Ebe, Yuki**
  **Osaka, 567-8680 (JP)**
- **Wakiya, Shinsuke**
  **Osaka, 532-8550 (JP)**

(74) Representative: **HOFFMANN EITLE**
**Patent- und Rechtsanwälte**
**Arabellastrasse 4**
**81925 München (DE)**

# (54) Encapsulating sheet, producing method of optical semiconductor device, optical semiconductor device, and lighting device

(57) An encapsulating sheet, encapsulating an optical semiconductor element (11), includes a first layer (3) which contains a phosphor and a second layer (4) which contains a phosphor, is laminated on the first layer (3), and encapsulates the optical semiconductor element (11). The ratio of the volume of the phosphor in the first layer (3) to that of the phosphor in the second layer (4) is 90:10 to 55:45.

FIG.3

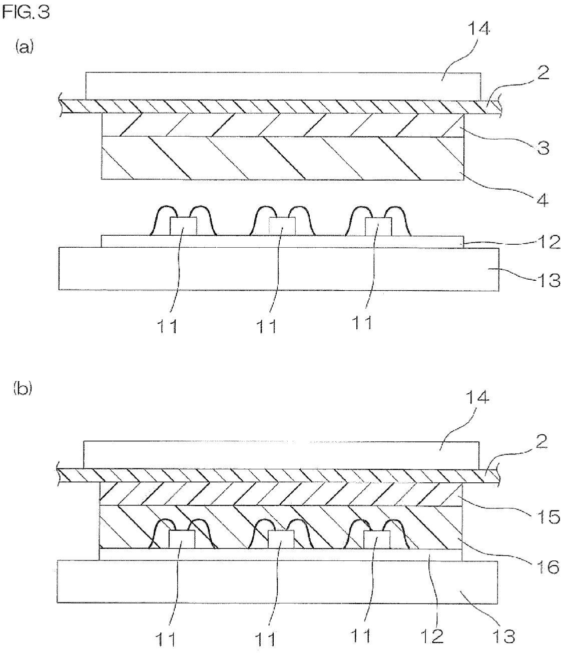


EP 2 610 932 A1

Printed by Jouve, 75001 PARIS (FR)

## Description

BACKGROUND OF THE INVENTION

Field of the Invention

The present invention relates to an encapsulating sheet, a method for producing an optical semiconductor device using the encapsulating sheet, an optical semiconductor device, and a lighting device.

Description of Related Art

Conventionally, it has been known that an optical semiconductor element such as a light emitting diode (LED) is encapsulated by a resin.

It has been proposed that an optical semiconductor element is encapsulated using, for example, an optical semiconductor encapsulating sheet which includes a first resin layer containing a phosphor and a second resin layer encapsulating the optical semiconductor element, so that an optical semiconductor device is obtained (ref: for example, Japanese Unexamined Patent Publication No. 2010-123802).

In the optical semiconductor device, for example, when the phosphor is composed of a YAG phosphor and the optical semiconductor element is composed of a blue light emitting diode, white light can be obtained by color mixing of blue light from the blue light emitting diode and yellow light from the YAG phosphor.

SUMMARY OF THE INVENTION

However, in the optical semiconductor encapsulating sheet described in the above-described Japanese Unexamined Patent Publication No. 2010-123802, while the blue light which travels along a laminating direction of the first resin layer and the second resin layer is appropriately color mixed with the yellow light from the YAG phosphor to be converted into the white light, the blue light which travels in a direction different from the laminating direction may not be converted into the white light because the color mixing balance with the yellow light from the YAG phosphor is destroyed.

For example, when a phosphor is not contained in the second resin layer, there may be a case where the blue light from the blue light emitting diode does not pass through the first resin layer and leaks from a side surface (a side surface in a direction perpendicular to the laminating direction) of the second resin layer.

That is, in this case, when the optical semiconductor device is visually recognized from the direction perpendicular to the laminating direction, it seems that the optical semiconductor device emits the blue light.

When a small amount of the phosphor is contained in the second resin layer, when the optical semiconductor device is visually recognized from the direction perpendicular to the laminating direction, the blue light from the blue light emitting diode becomes more intense than the yellow light from the YAG phosphor, so that it seems that the optical semiconductor device emits the blue light.

When a large amount of the phosphor is contained in the second resin layer, when the optical semiconductor device is visually recognized from the direction perpendicular to the laminating direction, the yellow light from the "YAG phosphor becomes more intense than the blue light from the blue light emitting diode, so that it seems that the optical semiconductor device emits the yellow light.

In this way, the chromaticity of light from the optical semiconductor device changes in accordance with an angle (a viewing angle) from which the optical semiconductor device is visually recognized.

It is an object of the present invention to provide an encapsulating sheet which is capable of reducing a change in the chromaticity of light from an optical semiconductor device in accordance with a viewing angle, a method for producing an optical semiconductor device, an optical semiconductor device, and a lighting device.

An encapsulating sheet of the present invention, encapsulating an optical semiconductor element, includes a first layer which contains a phosphor and a second layer which contains a phosphor, is laminated on the first layer, and encapsulates the optical semiconductor element, wherein the ratio of the volume of the phosphor in the first layer to that of the phosphor in the second layer is 90:10 to 55:45.

In the encapsulating sheet of the present invention, it is preferable that the first layer and the second layer contain a silicone resin.

In the encapsulating sheet of the present invention, it is preferable that the phosphor contained in the first layer and the phosphor contained in the second layer are $(Sr, Ba)_2SiO_4$:Eu.

In the encapsulating sheet of the present invention, it is preferable that the total amount of the phosphor contained in the first layer and the phosphor contained in the second layer is adjusted to be 0.32 to 0.37 of CIE-y in a total luminous flux measurement when the optical semiconductor element which is encapsulated is allowed to emit light.

A method for producing an optical semiconductor device of the present invention includes the steps of allowing

the above-described encapsulating sheet to be opposed to the optical semiconductor element so that the second layer faces the optical semiconductor element and pressing at least one of the encapsulating sheet and the optical semiconductor element which are opposed to each other toward the direction in which they come close to each other to encapsulate the optical semiconductor element.

An optical semiconductor device of the present invention includes an optical semiconductor element; a first fluorescent layer which contains a phosphor and is spaced in opposed relation to the optical semiconductor element; and a second fluorescent layer which contains a phosphor, is interposed between the optical semiconductor element and the first fluorescent layer, and encapsulates the optical semiconductor element, wherein the ratio of the volume of the phosphor in the first fluorescent layer to that of the phosphor in the second fluorescent layer is 90:10 to 55:45.

In the optical semiconductor device of the present invention, it is preferable that the first fluorescent layer and the second fluorescent layer contain a silicone resin.

In the optical semiconductor device of the present invention, it is preferable that a distance between the surface of the first fluorescent layer and the optical semiconductor element in an opposing direction of the optical semiconductor element to the first fluorescent layer is shorter than that between the surface of the second fluorescent layer and the optical semiconductor element in a direction perpendicular to the opposing direction.

In the optical semiconductor device of the present invention, it is preferable that the phosphor contained in the first fluorescent layer and the phosphor contained in the second fluorescent layer are $(Sr, Ba)_2SiO_4$:Eu.

In the optical semiconductor device of the present invention, it is preferable that the total amount of the phosphor contained in the first fluorescent layer and the phosphor contained in the second fluorescent layer is adjusted to be 0.32 to 0.37 of CIE-y in a total luminous flux measurement.

A lighting device of the present invention includes the above-described optical semiconductor device.

According to the encapsulating sheet of the present invention, the ratio of the volume of the phosphor in the first layer to that of the phosphor in the second layer is adjusted to be 90:10 to 55:45.

Therefore, when the optical semiconductor element is encapsulated by the encapsulating sheet of the present invention and the optical semiconductor device is produced, the ratio of the volume of the phosphor in the first fluorescent layer to that of the phosphor in the second fluorescent layer can be easily adjusted to be 90:10 to 55:45.

As a result, a change in the chromaticity of light from the optical semiconductor device or the lighting device in accordance with a viewing angle can be easily reduced.

BRIEF DESCRIPTION OF THE DRAWINGS

FIG. 1 shows a sectional view of one embodiment of an encapsulating sheet of the present invention.

FIG. 2 shows explanatory views for illustrating a method for producing the encapsulating sheet shown in FIG. 1:

(a) illustrating a step of forming a phosphor layer on a release film and
(b) illustrating a step of forming an encapsulating resin layer on the phosphor layer.

FIG. 3 shows explanatory views for illustrating one embodiment of a method for producing an optical semiconductor device of the present invention:

(a) illustrating a step of allowing the encapsulating sheet to be opposed to an optical semiconductor element and
(b) illustrating a step of encapsulating the optical semiconductor element.

FIG 4 shows a schematic configuration view for illustrating one embodiment of an optical semiconductor device of the present invention.

FIG. 5 shows a graph for illustrating a change in the chromaticity in accordance with a viewing angle in the optical semiconductor devices in Examples and Comparative Examples.

FIG. 6 shows a plan view of one embodiment of a lighting device of the present invention.

FIG. 7 shows an A-A sectional view of the lighting device shown in FIG. 6.

DETAILED DESCRIPTION OF THE INVENTION

FIG. 1 shows a sectional view of one embodiment of an encapsulating sheet of the present invention. FIG. 2 shows explanatory views for illustrating a method for producing the encapsulating sheet shown in FIG. 1.

As shown in FIG. 1, an encapsulating sheet 1 includes a release film 2 in a long-length flat belt shape; a phosphor layer 3, as a first layer, laminated on the release film 2; and an encapsulating resin layer 4, as a second layer,

laminated on the phosphor layer 3. The encapsulating sheet 1 is used so as to encapsulate, for example, an optical semiconductor element such as a light emitting diode (LED). In the embodiment, a case where a blue light emitting diode as an optical semiconductor element is encapsulated is described.

In order to produce the encapsulating sheet 1, as shown in FIG. 2 (a), first, the phosphor layer 3 is formed on the release film 2.

The release film 2 is formed of a resin film. Examples of the resin film include a polyethylene terephthatate film, a polystyrene film, a polypropylene film, a polycarbonate film, an acrylic film, a silicone resin film, a styrene resin film, and a fluorine resin film. The surface of the release film 2 may be subjected to a release treatment.

The thickness of the release film 2 is, for example, 20 to 100 μm, or preferably 30 to 50 μm. When the thickness of the release film 2 is within the above-described range, an excellent handling ability (the handling ability at the time of peeling the release film 2 from the encapsulating sheet 1) can be achieved, while an increase in cost is suppressed.

The phosphor layer 3 contains, as essential components, a phosphor and a molding resin.

Examples of the phosphor include a yellow phosphor which is capable of converting blue light into yellow light and a red phosphor which is capable of converting blue light into red light.

Examples of the yellow phosphor include a silicate phosphor such as $(Sr, Ba)_2SiO_4$:Eu (barium orthosilicate (BOS)), an α-sialon phosphor such as Ca-α-SiAlON:Eu, and a garnet type phosphor such as $Y_3Al_5O_{12}$:Ce (YAG:Ce) and $Tb_3Al_3O_{12}$:Ce (TAG:Ce).

An example of the red phosphor includes a nitride phosphor such as $CaAlSiN_3$:Eu.

As the phosphor, preferably, a yellow phosphor is used, more preferably, a silicate phosphor is used, or even more preferably, $(Sr, Ba)_2SiO_4$:Eu (barium orthosilicate (BOS)) is used. When the phosphor is $(Sr, Ba)_2SiO_4$:Eu (barium orthosilicate (BOS)), a phosphor having various light emission wavelengths can be easily obtained and thus, there is an effect that, in an optical semiconductor device 10 (described later), variations in light emission wavelength for converting the blue light into the yellow light can be diversely achieved.

The phosphor is, for example, in a particle shape and in a volume-based particle size distribution obtained by measuring by a laser diffraction scattering particle size distribution measurement method, the particle size thereof at 50 % cumulative percent passing (that is, a median size (D50)) from the small particle size side is, for example, 0.1 to 100 μm, or preferably I to 30 μm.

An example of the molding resin includes a resin which transmits light such as a silicone resin, an epoxy resin, a styrene resin, an acrylic resin, a polycarbonate resin, a urethane resin, and a polyolefin resin. Preferably, a silicone resin is used. These molding resins can be used alone (one only) or in combination of two or more. When the molding resin contains a silicone resin, there is an effect of being capable of enduring a wide range of temperature/humidity conditions and the extreme environment, in view of physical properties and electrical properties.

The molding resin contains the silicone resin at a content ratio of, preferably 70 mass % or more, more preferably 90 mass % or more, or even more preferably 100 mass % (that is the silicone resin only).

The silicone resin is commercially available. An example of the commercially available product thereof includes a silicone elastomer such as ERASTOSIL series including ERASTOSIL LR7665 (manufactured by WACKER ASAHIKASEI SILICONE CO., LTD.).

When the silicone resin is contained in the molding resin, by adjusting the cross-linking density of the silicone resin, the elasticity of the phosphor layer 3 can be adjusted to be capable of maintaining a uniform thickness even by being subjected to an external force or a pressure at the time of encapsulation.

An additive, as an optional component, can be blended in the phosphor layer 3. Examples of the additive include curing agents, curing accelerators, oxidation inhibitors, modifiers, surfactants, dyes, pigments, discoloration inhibitors, and ultraviolet absorbers.

Also, as an optional component, organic particles such as silicone resin microparticles and inorganic particles such as silica microparticles, barium sulfate, barium carbonate, and barium titanate can be blended in the phosphor layer 3. These organic particles and inorganic particles can be used alone (one only) or in combination of two or more.

In order to form the phosphor layer 3, first, the phosphor is blended in the molding resin or a solution of the molding resin to be mixed, so that a molding resin composition is prepared.

The content proportion (solid content conversion, hereinafter defined as a mass proportion) of the phosphor by mass basis in the molding resin composition may be set by back calculation from the content proportion (hereinafter defined as a volume proportion) of the phosphor by volume basis contained in the phosphor layer 3 to be aimed at.

The volume proportion of the phosphor in the molding resin composition can be calculated by the following formula (1).

Formula (1):

The volume proportion of the phosphor = (the mass proportion of the phosphor / the specific gravity of the phosphor) ÷ {(the mass proportion of the phosphor / the specific gravity of the phosphor) + (the mass proportion of the molding resin / the specific gravity of the molding resin)}

Next, the obtained molding resin composition is applied onto the release film 2 to be dried, so that the phosphor layer 3 is obtained.

Examples of a method for applying the molding resin composition onto the release film 2 include a casting method, a spin coating method, or a roll coating method.

The molding resin composition applied onto the release film 2 is, though the conditions are not particularly limited, dried by heating at, for example, 80 to 150°C, or preferably 90 to 150°C for, for example, 5 to 60 minutes.

The thickness of the obtained phosphor layer 3 is, for example, 30 to 1000 μm, preferably 100 to 700 μm, or more preferably 300 to 600 μm.

The volume proportion of the phosphor in the obtained phosphor layer 3 is, though depending on the type of the phosphor, when the phosphor is $(Sr, Ba)_2SiO_4:Eu$, for example, 0.1 to 99.9 volume %, preferably 1 to 99 volume %, or more preferably 2 to 15 volume %.

Next, in order to produce the encapsulating sheet 1, as shown in FIG. 2 (b), the encapsulating resin layer 4 is formed on the phosphor layer 3.

The encapsulating resin layer 4 contains, as essential components, a phosphor and an encapsulating resin.

An example of the phosphor includes the same phosphor as that illustrated in the above-described phosphor layer 3.

An example of the encapsulating resin includes the same resin as the molding resin illustrated in the above-described phosphor layer 3. Preferably, a silicone resin is used. These encapsulating resins can be used alone (one only) or in combination of two or more. When the encapsulating resin contains a silicone resin, there is an effect of being capable of enduring a wide range of temperature/humidity conditions and the extreme environment, in view of physical properties and electrical properties.

As the silicone resin, preferably, a silicone resin having two reaction systems (the reaction systems in a curing reaction) and a modified silicone resin are used.

An example of the silicone resin having two reaction systems includes a silicone resin (for example, an encapsulating resin or the like prepared in Examples to be described later) having two reaction systems of a silanol condensation reaction and a hydrosilylation reaction.

An example of the modified silicone resin includes a silicone resin having a heterosiloxane skeleton in which a part of Si atoms in the siloxane skeleton in the silicone resin is replaced (for example, borosiloxane in which an Si atom is replaced with a B atom, aluminosiloxane in which an Si atom is replaced with an Al atom, phosphasiloxane in which an Si atom is replaced with a P atom, titanasiloxane in which an Si atom is replaced with a Ti atom, or the like).

Also, as an optional component, organic particles such as silicone resin microparticles and inorganic particles such as silica microparticles, barium sulfate, barium carbonate, and barium titanate can be blended in the encapsulating resin layer 4. These organic particles and inorganic particles can be used alone (one only) or in combination of two or more.

In order to form the encapsulating resin layer 4, first, the phosphor is blended in the encapsulating resin or a solution of the encapsulating resin to be mixed, so that an encapsulating resin composition is prepared.

The mass proportion (solid content conversion) of the phosphor in the encapsulating resin composition may be set by back calculation from the volume proportion of the phosphor contained in the encapsulating resin layer 4 to be aimed at in the same manner as the mass proportion of the phosphor in the molding resin composition described above.

The volume proportion of the phosphor in the encapsulating resin composition can be calculated by the following formula (2).

Formula (2):

The volume proportion of the phosphor = (the mass proportion of the phosphor / the specific gravity of the phosphor) ÷ {(the mass proportion of the phosphor / the specific gravity of the phosphor) + (the mass proportion of the encapsulating resin / the specific gravity of the encapsulating resin)}

The volume proportion of the phosphor = (the mass proportion of the phosphor / the specific gravity of the phosphor) ÷ {(the mass proportion of the phosphor / the specific gravity of the phosphor) + (the mass proportion of the encapsulating resin / the specific gravity of the encapsulating resin)}

Next, the obtained encapsulating resin composition is applied onto the phosphor layer 3 to be dried, so that the encapsulating resin layer 4 is obtained.

As a method for applying the encapsulating resin composition onto the phosphor layer 3, for example, the same method as that for applying the molding resin composition onto the release film 2 described above can be used.

The encapsulating resin composition applied onto the phosphor layer 3 is dried by heating at, for example, 50 to 160°C, or preferably 80 to 150°C for, for example, 5 to 300 minutes.

The thickness of the obtained encapsulating resin layer 4 is, in view of encapsulating properties and operating properties of the optical semiconductor element, and whitening thereof, for example, 30 to 2000 μm, preferably 200 to 1000 μm, or more preferably 400 to 800 μm.

The ratio of the thickness of the encapsulating resin layer 4 to that of the phosphor layer 3 is, for example, 5: 5 to 9:1, or preferably 5.5:4.5 to 7:3.

The volume proportion of the phosphor in the obtained encapsulating resin layer 4 is, though depending on the type of the phosphor, when the phosphor is (Sr, $Ba)_2SiO_4$:Eu, for example, 0.1 to 99.9 volume %, or preferably 0.1 to 4 volume %.

Preferably, the content ratio of the phosphor in the phosphor layer 3 and the content ratio of the phosphor in the encapsulating resin layer 4 are adjusted to be 0.32 to 0.37 of CIE-y in a total luminous flux measurement so that when a light emitting diode 11 (described later) which is encapsulated is allowed to emit light, the emitted light becomes white light. The CIE-y in the total luminous flux measurement is measured by an integrating sphere Measurement using, for example, an instantaneous multiple photometric system (MCPD-9800, manufactured by OTSUKA ELECTRONICS CO., LTD.) or the like.

The encapsulating resin layer 4 can be formed as a single layer or by laminating a plurality of layers, can be formed to have the above-described thickness.

In this way, the encapsulating sheet 1 is obtained. The shape and the size of the encapsulating sheet 1 is capable of being appropriately adjusted in accordance with the shape and the size of an object (the light emitting diode 11) to be encapsulated.

In the obtained encapsulating sheet 1, the ratio of the volume of the phosphor in the phosphor layer 3 to that of the phosphor in the encapsulating resin layer 4 is adjusted to be, for example, 90:10 to 55:45, or preferably 80:20 to 60:40.

FIG. 3 shows explanatory views for illustrating one embodiment of a method for producing an optical semiconductor device of the present invention. FIG. 4 shows a schematic configuration view for illustrating one embodiment of an optical semiconductor device of the present invention.

Next, a method for producing an optical semiconductor device by encapsulating the light emitting diode 11 using the obtained encapsulating sheet 1 is described.

As shown in FIG. 3 (a), in order to encapsulate the light emitting diodes 11, first, a board 12 on which a plurality of the light emitting diodes I that are arranged at spaced intervals to each other are mounted is disposed on a base board 13 which is a pressing device in a generally flat plate shape. Then, the encapsulating sheet 1 is disposed at the upper side of the board 12 so that the encapsulating resin layer 4 is opposed to the light emitting diodes 11 in the up-down direction.

Next, a pressing board 14 is allowed to come closer to the base board 13 so as to sandwich the encapsulating sheet 1 with the base board 13, then, the encapsulating sheet 1 is pressed toward the board 12, and thereafter, the

pressing board 14 is heated.

The temperature of the pressing board 14 is, for example, 120 to 200°C, or preferably 140 to 180°C.

The pressing force of the pressing board 14 with respect to the encapsulating sheet 1 is, for example, 0.01 to 10 MPa, or preferably 0.1 to 4 MPa.

Then, as shown in FIG. 3 (b), the light emitting diodes 11 are embedded in the encapsulating resin layer 4.

The phosphor layer 3 and the encapsulating resin layer 4 are subsequently heated, so that the phosphor layer 3 is cured to form a fluorescent layer 15 as a first fluorescent layer and the encapsulating resin layer 4 is cured to form an encapsulating layer 16 as a second fluorescent layer.

Lastly, as shown in FIG. 4, the release film 2 is peeled off, so that the optical semiconductor device 10 is obtained.

In the obtained optical semiconductor device 10, a distance X between the surface of the fluorescent layer 15 and the light emitting diodes 11 in an opposing direction (the up-down direction on the paper surface in FIG. 4) of the light emitting diodes 11 to the fluorescent layer 15 is, for example, 500 to 2000 μm, or preferably 600 to 1000 μm.

A distance Y between the surface of the encapsulating layer 16 and the light emitting diode I (the light emitting diode 11 which comes closest to the surface of the encapsulating layer 16) in a direction (the right-left direction on the paper surface in FIG. 4) perpendicular to the opposing direction is, for example, 500 to 5000 μm, or preferably 1000 to 3000 μm.

The ratio of the distance X to the distance Y is, for example, 1:10 to 4:1, or preferably 1:5 to 2:1.

According to the above-described encapsulating sheet 1, the ratio of the volume of the phosphor in the phosphor layer 3 to that of the phosphor in the encapsulating resin layer 4 is adjusted to be 90:10 to 55:45.

Therefore, according to the optical semiconductor device 10, the ratio of the volume of they phosphor in the fluorescent layer 15 to that of the phosphor in the encapsulating layer 16 is adjusted to be 90:10 to 55:45.

As a result, a change in the chromaticity of light from the optical semiconductor device 10 in accordance with a viewing angle can be easily reduced.

When the content proportion of the phosphor in the phosphor layer 3 exceeds the above-described range (90), there is a disadvantage that the chromaticity of light from the optical semiconductor device 10 significantly changes in accordance with an angle (a viewing angle) to visually recognize the optical semiconductor device 10. Also, when the content proportion of the phosphor in the encapsulating resin layer 4 exceeds the above-described range (45), there is a disadvantage that the chromaticity of light from the optical semiconductor device 10 significantly changes in accordance with an angle (a viewing angle) to visually recognize the optical semiconductor device 10.

According to the optical semiconductor device 10, as shown in FIG. 4, the distance Y between the side surface of the encapsulating layer 16 and the light emitting diode 11 is longer than the distance X between the top surface of the fluorescent layer 15 and the light emitting diodes 11.

Therefore, light which does not pass through the fluorescent layer 15 and passes through the side surface of the encapsulating layer 16 can be whitened by the phosphor in the encapsulating layer 16.

FIG. 6 shows a plan view of one embodiment of a lighting device of the present invention. FIG. 7 shows an A-A sectional view of the lighting device shown in FIG. 6.

The optical semiconductor device 10 is mounted on, for example, a lighting device 20.

As shown in FIGS. 6 and 7, the lighting device 20 is provided with a casing 21 which houses the optical semiconductor device 10.

The casing 21 is formed to be longitudinal in a predetermined direction and into a generally box shape. The casing 21 is provided with a base frame 23, a cover member 24, and a power supply cable 25.

The base trame 23 extends in the longitudinal direction of the casing 21 and is formed into a generally rectangular frame shape in plane view which is open toward the upper side (one side in a direction perpendicular to the predetermined direction, hereinafter the same). The base frame 23 constitutes a half of the lower side portion (one side in a direction perpendicular to the predetermined direction, hereinafter the same) of the casing 21.

The cover member 24 is formed into a generally U-shaped shape which extends in the longitudinal direction of the casing 21 so as to cover the base frame 23 from the upper side. In the cover member 24, a window portion 27 which extends in the longitudinal direction is formed to penetrate therethrough. A glass plate 26 is fitted in the window portion 27.

The power supply cable 25 is supported at one end portion in the longitudinal direction of the base frame 23 so as to communicate between the inside and the outside of the base frame 23. In the base frame 23, the power supply cable 25 is electrically connected to the board 12 in the optical semiconductor device 10.

The optical semiconductor device 10 is formed into a generally rectangular flat plate shape in plane view which extends in the longitudinal direction of the casing 21. In the optical semiconductor device 10, a plurality of the light emitting diodes 11 are arranged in parallel at spaced intervals to each other in the longitudinal direction on one piece of the board 12. A plurality of lenses 22 are provided in the optical semiconductor device 10.

Each of the plurality of the lenses 22 is provided corresponding to each of the plurality of the light emitting diodes 11. The lenses 22 are formed into convex lens shapes and are provided on the fluorescent layer 15 in the optical

semiconductor device 10. The lenses 22 orient light emitted from the light emitting diodes 11.

The lighting device 20 is provided with the above-described optical semiconductor device 10, so that a change in the chromaticity of light from the lighting device 20 in accordance with a viewing angle can be easily reduced.

In the above-described embodiment, the phosphor layer 3 and the encapsulating resin layer 4 are sequentially laminated on the release film 2. Alternatively, for example, each of the phosphor layer 3 and the encapsulating resin layer 4 is formed on another film, respectively and thereafter, the phosphor layer 3 and the encapsulating resin layer 4 may be attached to each other by a method such as a thermal compression bonding.

In the above-described embodiment, the release film 2 is peeled off after encapsulating the light emitting diodes 11 by the encapsulating sheet 1. Alternatively, for example, the light emitting diodes 11 may be encapsulated after peeling the release film 2 from the encapsulating sheet 1.

In the above-described embodiment, the encapsulating sheet 1 is pressurized with respect to the board 12 by the pressing board 14 in a generally flat plate shape. Alternatively, for example, pressurization can be performed using a metal molding die in a predetermined shape instead of the pressing board 14.

## Examples

While the present invention will be described hereinafter in further detail with reference to Examples and Comparative Examples, the present invention is not limited to these Examples and Comparative Examples.

1. Preparation of Molding Resin

An A liquid and a B liquid of ERASTOSIL LR7665 (manufactured by WACKER ASAHIKASEI SILICONE CO., LTD., a dimethylsiloxane skeleton derivative) were mixed at a ratio of 1:1, so that a molding resin was prepared. The specific gravity of the obtained molding resin was 1.0 g/cm$^3$.

2. Preparation of Encapsulating Resin

15.76 g (0.106 mol) of a vinyltrimethoxysilane and 2.80 g (0.0118 mol) of a (3-glycidoxypropyl)trimethoxysilane were blended with respect to 2031 g (0.177 mol) of a polysiloxane containing silanol groups at both ends (in the following formula (1), all of the $R_1$s are methyl, the average of "n" is 155, a number average molecular weight of 11500, a silanol group equivalent of 0.174 mmol/g) which was heated at 40°C and the obtained mixture was stirred and mixed.

The molar ratio (the number of moles of a silanol group/the total number of moles of a methoxysilyl group) of the silanol group (SiOH) in the polydimethylsiloxane containing silanol groups at both ends to the methoxysilyl group ($SiOCH_3$) in the vinyltrimethoxysilane and the (3-glycidoxypropyl)trimethoxysilane was 1/1.

After the stirring and mixing, 0.97 mL (a catalyst content: 0.88 mmol, corresponding to 0.50 mol with respect to 100 mol of the polydimethylsiloxane containing silanol groups at both ends) of a methanol solution of tetramethylammonium hydroxide (a condensation catalyst, a concentration of 10 mass %) was added to the obtained mixture to be stirred at 40°C for 1 hour. Thereafter, the obtained mixture (oil) was stirred under a reduced pressure (10 mmHg) at 40°C for 1 hour and a volatile component (methanol or the like) was removed.

Thereafter, the pressure in the system was brought back to the normal pressure and then, 44.5 g (0.022 mol) of an organohydrogensiloxane (manufactured by Shin-Etsu Chemical Co., Ltd., a number average molecular weight of 2000, a hydrosilyl group equivalent of 7.14 mmol/g) was added to the reaction product to be stirred at 40°C for 1 hour.

The molar ratio ($CH_2$=CH-/SiH) of the vinyl group ($CH_2$=CH-) in the vinyltrimethoxysilane to the hydrosilyl group (SiH group) in the organohydrogensiloxane was 1/3.

Thereafter, 0.13 mL (as a platinum, corresponding to $5.8 \times 10^{-3}$ parts by mass with respect to 100 parts by mass of the organohydrogensiloxane) of a siloxane solution of a platinum carbonyl complex (an addition catalyst, a platinum concentration of 2 mass %) was added to the system to be stirred at 40°C for 10 minutes, so that an encapsulating resin was obtained.

The specific gravity of the obtained encapsulating resin was 1.0 g/cm$^3$.

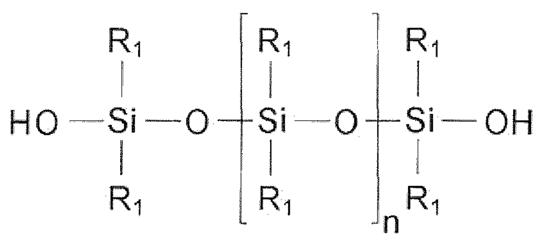 (1)

3. Examples and Comparative Examples

Example 1

(Production of Encapsulating Sheet)

15 g of a phosphor ((Sr, Ba)$_2$SiO$_4$:Eu (barium orthosilicate), a specific gravity: 4.8 g/cm$^3$) was blended in 85 g of a molding resin to be stirred and mixed for 1 hour, so that a molding resin composition containing 15 mass % of the phosphor was prepared.
The obtained molding resin composition was applied onto a release film (a polyester film: SS4C, manufactured by Nippa CO., LTD., a thickness of 50 μm) with a thickness of 400 μm to be dried at 100°C for 10 minutes, so that a phosphor layer laminated on the release film was formed (ref: FIG. 2 (a)).
Next, 7 g of a phosphor ((Sr, Ba)$_2$SiO$_4$:Eu (barium orthosilicate) was blended in 93 g of an encapsulating resin to be mixed, so that an encapsulating resin composition containing 7 mass % of the phosphor was prepared.
The obtained encapsulating resin composition was applied onto the phosphor layer with a thickness of 600 μm to be dried at 135°C for 5 minutes. In this way, the encapsulating resin composition was semi-cured, so that an encapsulating resin layer was formed (ref: FIG. 2 (b)).
In this way, an encapsulating sheet was obtained.
The proportion of the volume of the phosphor contained in the phosphor layer to that of the phosphor contained in the encapsulating resin layer is shown in Table 1.
(Production of Semiconductor Device)
The encapsulating sheet was disposed with respect to an LED array board (an LED array board obtained by forming a concave portion with 12 mm ϕ and a depth of 150 μm in a metal board having an external size of 22 mm × 15 mm and allowing 9 pieces (3 pieces (longitudinal) × 3 pieces (lateral)) of blue light emitting diode chips to be mounted therein at intervals of 3 mm) so that the encapsulating resin layer was opposed to the blue light emitting diode chips (ref: FIG. 3 (a)).
Using a pressing board made of a metal, the encapsulating sheet was heated at 160°C and pressed with respect to the blue light emitting diode chips at a pressure of 0.1. MPa for 5 minutes, so that the blue light emitting diode chips were encapsulated.
Lastly, the release film was peeled off, so that an optical semiconductor device was obtained.
Example 2

(Production of Encapsulating Sheet)

An encapsulating sheet was obtained in the same manner as in the above-described Example 1, except that 16.5 mass % of the phosphor was contained in the molding resin composition and 6 mass % of the phosphor was contained in the encapsulating resin composition.
The proportion of the volume of the phosphor contained in the phosphor layer to that of the phosphor contained in the encapsulating resin layer is shown in Table 1.
(Production of Optical Semiconductor Device)
An optical semiconductor device was obtained by encapsulating the blue light emitting diode chips using the obtained encapsulating sheet in the same manner as in the above-described Example 1.
Example 3

(Production of Encapsulating Sheet)

17 g of a phosphor ((Sr, Ba)$_2$SiO$_4$:Eu (barium orthosilicate)) was blended in 83 g of a molding resin to be stirred and mixed for 1 hour, so that a molding resin composition containing 17 mass % of the phosphor was prepared.
The obtained molding resin composition was applied onto a release film (a polyester film: SS4C, manufactured by Nippa CO., LTD., a thickness of 50 μm) with a thickness of 500 μm to be dried at 100°C for 10 minutes, so that a phosphor layer laminated on the release film was formed (ref: FIG. 2 (a)).
Next, 5 g of a phosphor ((Sr, Ba)$_2$SiO$_4$:Eu (barium orthosilicate)) was blended in 95 g of an encapsulating resin to be mixed, so that an encapsulating resin composition containing 5 mass % of the phosphor was prepared.
The obtained encapsulating resin composition was applied onto the phosphor layer with a thickness of 600 μm to be dried at 135°C for 5 minutes. In this way, the encapsulating resin composition was semi-cured, so that an encapsulating resin layer was formed (ref: FIG. 2 (b)).
In this way, an encapsulating sheet was obtained.
The proportion of the volume of the phosphor contained in the phosphor layer to that of the phosphor contained

in the encapsulating resin layer is shown in Table 1.

Example 4

(Production of Encapsulating Sheet)

An encapsulating sheet was obtained in the same manner as in the above-described Example 3, except that 20 mass % of the phosphor was contained in the molding resin composition and 3 mass % of the phosphor was contained in the encapsulating resin composition.

The proportion of the volume of the phosphor contained in the phosphor layer to that of the phosphor contained in the encapsulating resin layer is shown in Table 1.

(Production of Optical Semiconductor Device)

An optical semiconductor device was obtained by encapsulating the blue light emitting diode chips using the obtained encapsulating sheet in the same manner as in the above-described Example 1.

Comparative Example 1

(Production of Encapsulating Sheet)

An encapsulating sheet was obtained in the same manner as in the above-described Example 3, except that 23 mass % of the phosphor was contained in the molding resin composition and 1 mass % of the phosphor was contained in the encapsulating resin composition.

The proportion of the volume of the phosphor contained in the phosphor layer to that of the phosphor contained in the encapsulating resin layer is shown in Table 1.

(Production of Optical Semiconductor Device)

An optical semiconductor device was obtained by encapsulating the blue light emitting diode chips using the obtained encapsulating sheet in the same manner as in the above-described Example 1.

Comparative Example 2

(Production of Encapsulating Sheet)

An encapsulating sheet was obtained in the same manner as in the above-described Example 1 except that 63 mass % of the phosphor was contained in the molding resin composition and the phosphor was not contained in the encapsulating resin composition.

The proportion of the volume of the phosphor contained in the phosphor layer to that of the phosphor contained in the encapsulating resin layer is shown in Table 1.

(Production of Optical Semiconductor Device)

All optical semiconductor device was obtained by encapsulating the blue light emitting diode chips using the obtained encapsulating sheet in the same manner as in the above-described Example 1.

Comparative Example 3

(Production of Encapsulating Sheet)

An encapsulating sheet was obtained in the same manner as in the above-described Example 1, except that 13.5 mass % of the phosphor was contained in the encapsulating resin composition and the encapsulating resin layer was formed on the release sheet without forming the phosphor layer.

The proportion of the volume of the phosphor contained in the phosphor layer to that of the phosphor contained in the encapsulating resin layer is shown in Table 1.

(Production of Optical Semiconductor Device)

An optical semiconductor device was obtained by encapsulating the blue light emitting diode chips using the obtained encapsulating sheet in the same manner as in the above-described Example 1.

4. Evaluation of Luminescence Measurement of Optical Semiconductor Device

(1) Evaluation of Light Distribution Properties

The optical semiconductor devices obtained in Examples and Comparative Examples were lit up at 270 mA. The chromaticity (CIE-y) was measured with an LED light distribution measurement system (GP-1000, manufactured by OTSUKA ELECTRONICS CO., LTD.) while a viewing angle was changed in a range of 0° (an opposing direction of the fluorescent layer to the light emitting diodes) to 85° (a direction perpendicular to the opposing direction). The results are shown in FIG. 5.

A difference (a maximum chromaticity difference) between the maximum chromaticity and the minimum chromaticity which was measured is shown in Table 1. The smaller the maximum chromaticity difference shows that the

chromaticity change in accordance with the viewing angle is smaller and that the light distribution properties are more excellent.

The color of light emitted from the side surface (the surface in a direction perpendicular to the opposing direction) of the optical semiconductor device was visually evaluated in accordance with the following criteria. The results are shown in Table 1.

(Evaluation Criteria of Visual evaluation)

Good: Light seems to be white.
Bad: Light seems to be blue or yellow.

(2) Total Luminous Flux Measurement

The optical semiconductor devices obtained in Examples and Comparative Examples were lit up at 270 mA. The chromaticity (CIE,y) was measured by an integrating sphere measurement using an instantaneous multiple photometric system (MCPD-9800, manufactured by OTSUKA ELECTRONICS CO., LTD.). The results are shown in Table 1.

Table 1

| | Thickness of Each of Layers (μm) | | Volume Proportion of Phosphor | | Light Distribution Properties | | Total Luminous Flux |
|---|---|---|---|---|---|---|---|
| | Phosphor Layer | Encapsulating Resin Layer | Phosphor Layer | Encapsulating Resin Layer | Maximum Chromaticity Difference | Visual Evaluation | CIE-y |
| Ex. 1 | 400 | 600 | 61 | 39 | 0.034 | Good | 0.34 |
| Ex. 2 | 400 | 600 | 67 | 33 | 0.017 | Good | 0.35 |
| Ex. 3 | 500 | 600 | 76 | 24 | 0.017 | Good | 0.33 |
| Ex. 4 | 500 | 600 | 87 | 13 | 0.056 | Good | 0.33 |
| Comp. Ex. 1 | 500 | 600 | 96 | 4 | 0.122 | Bad | 0.33 |
| Comp. Ex. 2 | 500 | 600 | 100 | 0 | 0.146 | Bad | 0.33 |
| Comp. Ex. 3 | 0 | 600 | 0 | 100 | 0.067 | Bad | 0.34 |

## Claims

1. An encapsulating sheet, encapsulating an optical semiconductor element, comprising: a first layer which contains a phosphor and
a second layer which contains a phosphor, is laminated on the first layer, and encapsulates the optical semiconductor element, wherein
the ratio of the volume of the phosphor in the first layer to that of the phosphor in the second layer is 90:10 to 55:45.

2. The encapsulating sheet according to claim 1, wherein
the first layer and the second layer contain a silicone resin.

3. The encapsulating sheet according to claim 1 or 2, wherein
the phosphor contained in the first layer and the phosphor contained in the second layer are $(Sr, Ba)_2SiO_4$:Eu.

4. The encapsulating sheet according to claim 1, 2 or 3, wherein
the total amount of the phosphor contained in the first layer and the phosphor contained in the second layer is

adjusted to be 0.32 to 0.37 of CIE-y in a total luminous flux measurement when the optical semiconductor element which is encapsulated is allowed to emit light.

**5.** A method for producing an optical semiconductor device comprising the steps of: preparing an encapsulating sheet comprising:

a first layer which contains a phosphor and
a second layer which contains a phosphor, is laminated on the first layer, and encapsulates the optical semiconductor element, and
the ratio of the volume of the phosphor in the first layer to that of the phosphor in the second layer is 90:10 to 55:45,
allowing the encapsulating sheet to be opposed to the optical semiconductor element so that the second layer faces the optical semiconductor element, and
pressing at least one of the encapsulating sheet and the optical semiconductor element which are opposed to each other toward the direction in which they come close to each other to encapsulate the optical semiconductor element.

**6.** An optical semiconductor device comprising:

an optical semiconductor element;
a first fluorescent layer which contains a phosphor and is spaced in opposed relation to the optical semiconductor element; and
a second fluorescent layer which contains a phosphor, is interposed between the optical semiconductor element and the first fluorescent layer, and encapsulates the optical semiconductor element, wherein
the ratio of the volume of the phosphor in the first fluorescent layer to that of the phosphor in the second fluorescent layer is 90:10 to 55:45.

**7.** The optical semiconductor device according to claim 6, wherein
the first fluorescent layer and the second fluorescent layer contain a silicone resin.

**8.** The optical semiconductor device according to claim 6 or 7, wherein
a distance between the surface of the first fluorescent layer and the optical semiconductor element in an opposing direction of the optical semiconductor element to the first fluorescent layer is shorter than that between the surface of the second fluorescent layer and the optical semiconductor element in a direction perpendicular to the opposing direction.

**9.** The optical semiconductor device according to claim 6, 7 or 8, wherein
the phosphor contained in the first fluorescent layer and the phosphor contained in the second fluorescent layer are $(Sr, Ba)_2SiO_4$:Eu.

**10.** The optical semiconductor device according to any of claims 6 to 9, wherein
the total amount of the phosphor contained in the first fluorescent layer and the phosphor contained in the second fluorescent layer is adjusted to be 0.32 to 0.37 of CIE-y in a total luminous flux measurement.

**11.** A lighting device comprising an optical semiconductor device according to any of claims 6 to 10.

FIG. 1

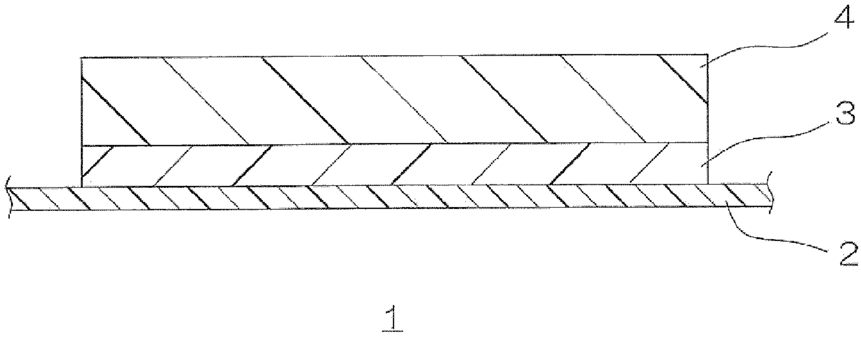


FIG. 2

(a)

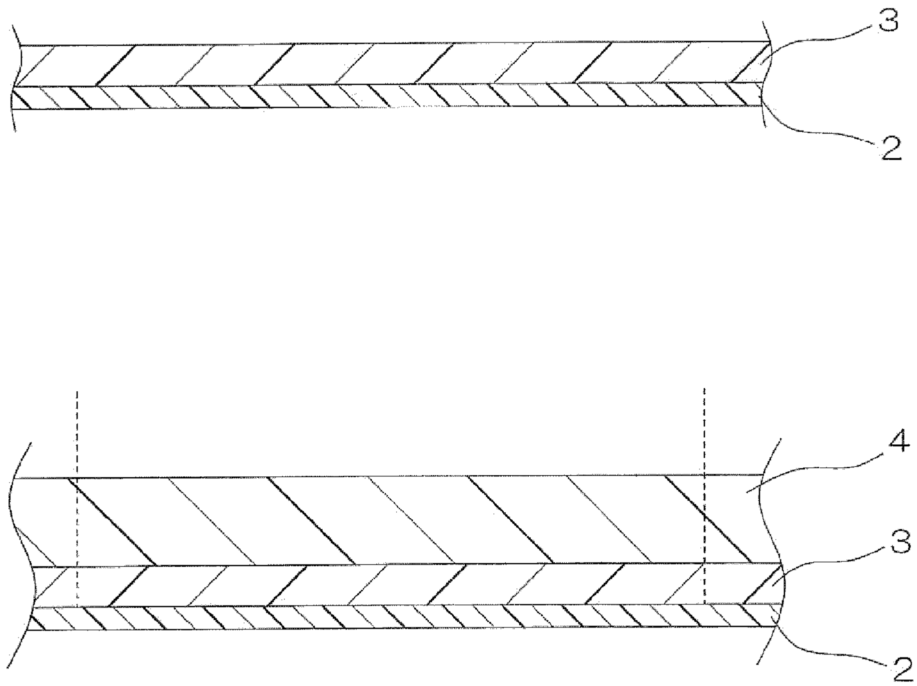

FIG. 3

(a)

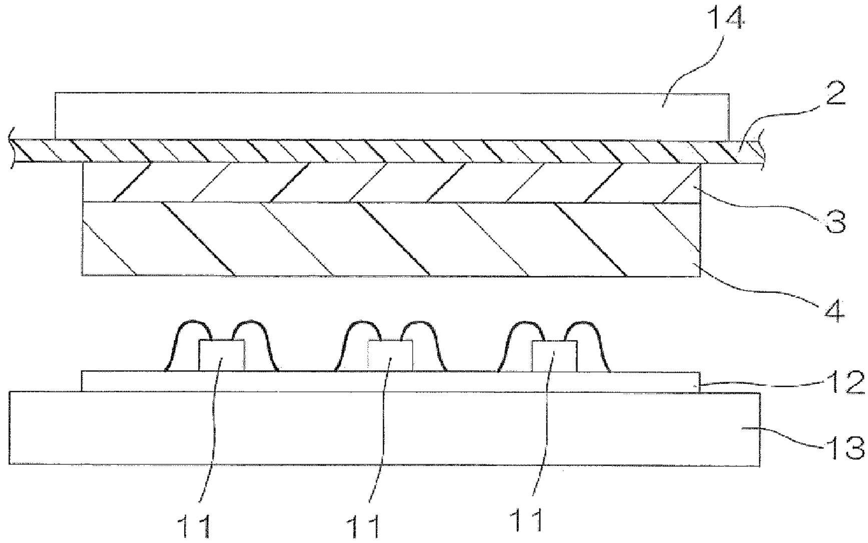


(b)

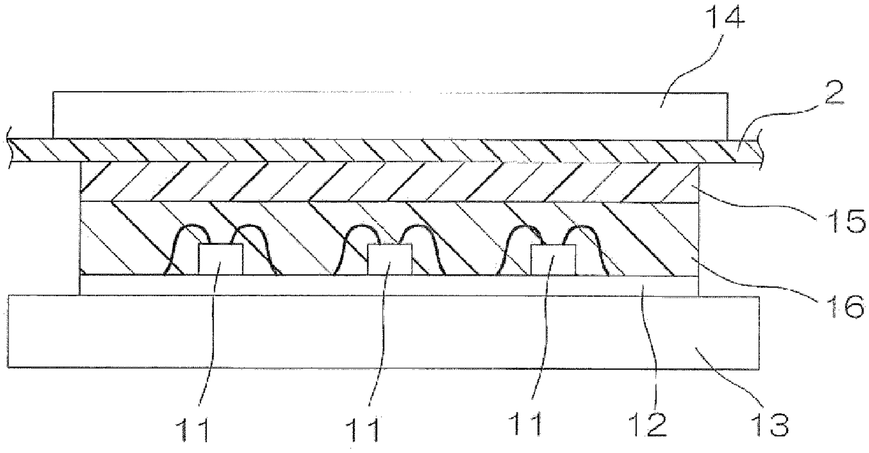


FIG. 4

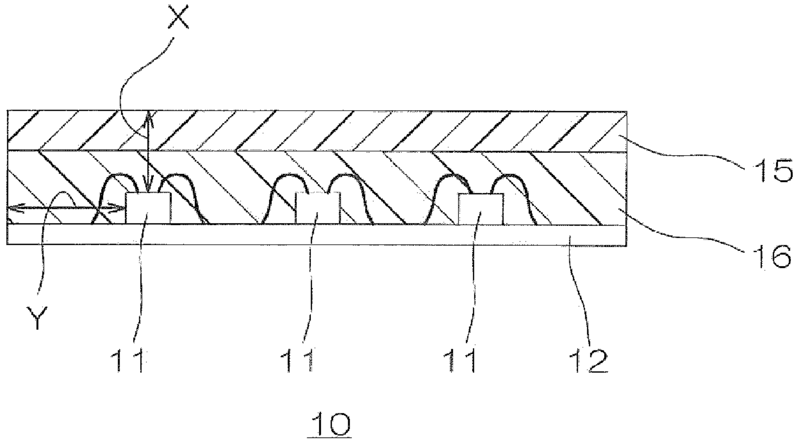

FIG. 5

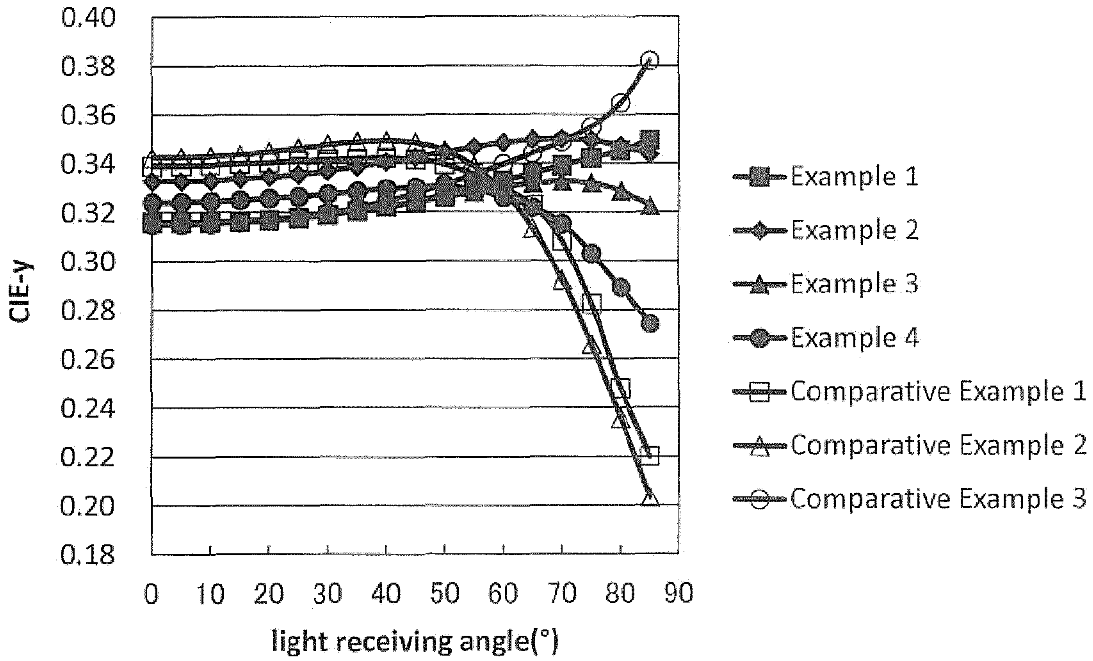
0.40
0.38
0.36
0.34
0.32
0.30
0.28
0.26
0.24
0.22
0.20
0.18
CIE-y
0
10
20
30
40
50
60
70
80
90
light receiving angle(°)
Example 1
Example 2
Example 3
Example 4
Comparative Example 1
Comparative Example 2
Comparative Example 3

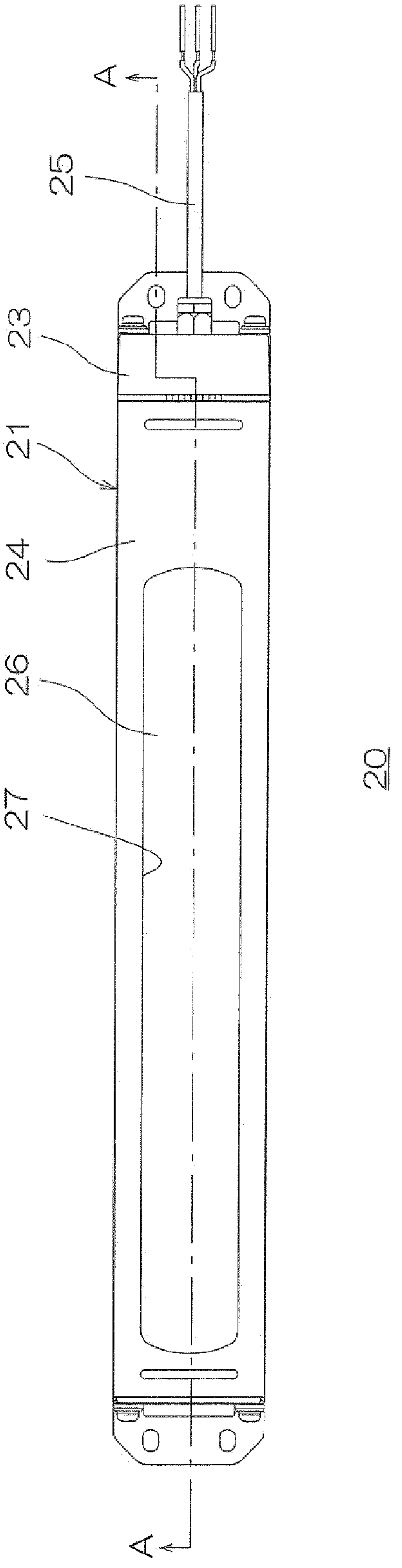


FIG.6

FIG. 7

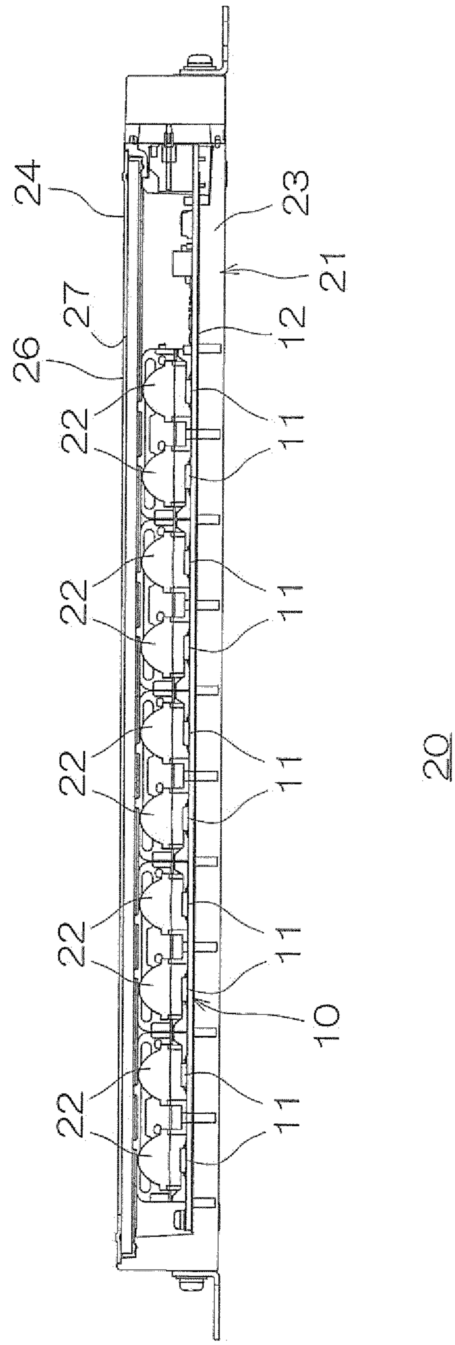

Europäisches Patentamt
European Patent Office
Office européen des brevets

# EUROPEAN SEARCH REPORT

Application Number
EP 12 19 9447

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/156081 A1 (DE CARVALHO ESTEVES ANA C [NL] ET AL) 30 June 2011 (2011-06-30)<br>* the whole document * | 1-11 | INV.<br>H01L33/50<br><br>ADD.<br>C09K11/77 |
| A | US 2007/001568 A1 (KANEKO KEI [JP] ET AL) 4 January 2007 (2007-01-04)<br>* paragraph [0049] * | 1,2,7 | |
| A | WO 2011/129429 A1 (HITACHI LTD [JP]; KOBAYASHI REO [JP]; OKAZAKI CHOICHIRO [JP]; IMAMURA)<br>20 October 2011 (2011-10-20)<br>* abstract *<br>* paragraphs [0025], [0032] * | 1-3,7,9 | |
| A | US 2009/179207 A1 (CHITNIS ASHAY [US] ET AL) 16 July 2009 (2009-07-16)<br>* abstract *<br>* paragraphs [0036], [0073], [0100] * | 1,2,7 | |

TECHNICAL FIELDS SEARCHED (IPC)

H01L
C09K

The present search report has been drawn up for all claims

1

| Place of search | Date of completion of the search | Examiner |
|---|---|---|
| The Hague | 11 April 2013 | Gijsbertsen, Hans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 12 19 9447

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2013

| Patent document cited in search report | Publication date | Patent family member(s) | Publication date |
|---|---|---|---|
| US 2011156081 A1 | 30-06-2011 | CN 102159664 A | 17-08-2011 |
| | | EP 2328994 A1 | 08-06-2011 |
| | | JP 2012503307 A | 02-02-2012 |
| | | KR 20110057239 A | 31-05-2011 |
| | | RU 2011115069 A | 27-10-2012 |
| | | TW 201022399 A | 16-06-2010 |
| | | US 2011156081 A1 | 30-06-2011 |
| | | WO 2010032179 A1 | 25-03-2010 |
| US 2007001568 A1 | 04-01-2007 | JP 4557824 B2 | 06-10-2010 |
| | | JP 2007013053 A | 18-01-2007 |
| | | US 2007001568 A1 | 04-01-2007 |
| | | US 2011171761 A1 | 14-07-2011 |
| WO 2011129429 A1 | 20-10-2011 | JP 2011228344 A | 10-11-2011 |
| | | WO 2011129429 A1 | 20-10-2011 |
| US 2009179207 A1 | 16-07-2009 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010123802 A